(19) Europäisches Patentamt
European Patent Office
Office européen des brevets

(11) **EP 4 469 811 B1**

(12) **EUROPÄISCHE PATENTSCHRIFT**

(45) Veröffentlichungstag und Bekanntmachung des Hinweises auf die Patenterteilung:
**09.07.2025 Patentblatt 2025/28**

(21) Anmeldenummer: **23702263.7**

(22) Anmeldetag: **25.01.2023**

(51) Internationale Patentklassifikation (IPC):
**G01R 27/20** (2006.01)　　**G01R 27/18** (2006.01)

(52) Gemeinsame Patentklassifikation (CPC):
**G01R 27/18**

(86) Internationale Anmeldenummer:
**PCT/EP2023/051752**

(87) Internationale Veröffentlichungsnummer:
**WO 2023/144179 (03.08.2023 Gazette 2023/31)**

(54) **VERFAHREN UND VORRICHTUNG ZUM BESTIMMEN EINER ERDUNGSIMPEDANZ**

METHOD AND DEVICE FOR DETERMINING A GROUNDING IMPEDANCE

PROCÉDÉ ET DISPOSITIF DE DÉTERMINATION D'UNE IMPÉDANCE DE MISE À LA TERRE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **28.01.2022 AT 500402022**

(43) Veröffentlichungstag der Anmeldung:
**04.12.2024 Patentblatt 2024/49**

(73) Patentinhaber: **Omicron electronics GmbH
6833 Klaus (AT)**

(72) Erfinder: **SCHMIDBAUER, Josef
5020 Salzburg (AT)**

(74) Vertreter: **Kraus & Lederer PartGmbB
Thomas-Wimmer-Ring 15
80539 München (DE)**

(56) Entgegenhaltungen:
**CN-A- 113 009 237　　CN-B- 109 342 821
US-A- 5 365 179**

- **HARID N ET AL: "Computation model for ground potential and current distribution in ground impedance measurements at high-voltage towers", UNIVERSITIES POWER ENGINEERING CONFERENCE, 2007. UPEC 2007. 42ND INTERNATIONAL, IEEE, PISCATAWAY, NJ, USA, 4 September 2007 (2007-09-04), pages 806 - 811, XP031237628, ISBN: 978-1-905593-36-1**
- **GRIFFITHS H ET AL: "Proposal for measurement of earth impedance using variable frequency injection;Proposal for measurement of earth impedance using variable frequency injection", MEASUREMENT SCIENCE AND TECHNOLOGY, IOP, BRISTOL, GB, vol. 21, no. 8, 24 June 2010 (2010-06-24), pages 85102, XP020195928, ISSN: 0957-0233, DOI: 10.1088/0957-0233/21/8/085102**

**Beschreibung**

GEBIET DER ERFINDUNG

Die vorliegende Erfindung betrifft ein Verfahren zum Bestimmen einer Erdungsimpedanz einer Erdungsvorrichtung einer energietechnischen Einrichtung oder elektrischen Anlage, beispielsweise eines Freileitungsmastes, sowie eine entsprechende Vorrichtung zum Bestimmen einer Erdungsimpedanz einer Erdungsvorrichtung einer energietechnischen Einrichtung oder elektrischen Anlage.

HINTERGRUND

In den Ausbreitungswiderstand, wie er beispielsweise in EN 50522 definiert ist, fließen neben dem Erdungswiderstand des lokalen Erdungssystems auch andere Komponenten mit Erdungswirkung ein, wie z.B. an Freileitungen angeschlossene Erdseile und damit verbundene weitere Erdungssysteme. Insbesondere bei Wechselstromanlagen wird eine Erdungsimpedanz betrachtet, welche den Wechselstromwiderstand zwischen Erder und Bezugserde darstellt. Bei der Erdungsimpedanz kann neben dem Widerstandsbelag und Querleitwertsbelag auch der Induktivitätsbelag sowie der Kapazitätsbelag berücksichtigt werden. Die Erdungsimpedanz ergibt sich beispielsweise aus der Parallelschaltung der Ausbreitungswiderstände der zusammengeschlossenen Erder. Hierzu können beispielsweise die Impedanzen der angeschlossenen Erdseile von Freileitungen sowie die Metallmäntel von Kabeln zählen.

Das Betrachten des lokalen Anteils des Ausbreitungswiderstands, also eine Bestimmung der Erdungsimpedanz des lokalen Erdungssystems, kann notwendig sein, um einerseits die korrekte Errichtung einer (lokalen) Erdungsvorrichtung nachzuweisen (Vergleich mit berechneten/geplanten Werten), und andererseits um Korrosionseffekte an der Erdungsvorrichtung bei Wiederholungsprüfungen festzustellen. Würden hier die verbundenen Systeme mitberücksichtigt, so wäre lediglich eine Beurteilung bezüglich der Sicherheit des gesamten Systems, beispielsweise einer gesamten Freileitung, möglich, jedoch keine genaue Aussage über das lokale Erdungssystem von beispielsweise einem konkreten Freileitungsmast.

Um die lokale Erdungsimpedanz zu bestimmen, sind verschiedene Verfahren bekannt.

Bei einem Verfahren für Freileitungsmasten wird beispielsweise das Erdseil abgehoben und damit die Verbindung zu anderen Erdungssystemen temporär für den Zeitraum der Messung aufgetrennt. Dieses Verfahren liefert verhältnismäßig exakte Messwerte, erfordert jedoch einen enormen Aufwand. Beispielsweise werden speziell ausgebildete Industriekletterer benötigt, welche auf den Mast klettern und das Erdseil abheben. Dabei sind verschiedene Sicherheitsaspekte zu beachten. Beispielsweise können beim Abheben durch fließende Ausgleichsströme kleine Lichtbögen entstehen. Spezielle Sicherheitskleidung kann daher erforderlich sein, beispielsweise ein Kettenanzug. Weiterhin kann die Messung selbst ein Sicherheitsproblem darstellen, da während der Messung das Erdungssystem nicht voll funktionsfähig ist. Darüber hinaus kann das Trennen und Wiederherstellen der Verbindung eine Fehlerquelle darstellen.

Ein weiteres Verfahren verwendet eine Messung einer Stromverteilung mittels einer Strommesseinrichtung, beispielsweise mittels Stromzangen oder Sensoren, z.B. Rogowski-Sensoren. Diese Messung der Stromverteilung liefert im Allgemeinen hinreichend genaue Werte, erfordert jedoch eine phasenrichtige Strommessung an jeder relevanten Verbindung zwischen den Erdungssystemen, wie z.B. jedem Mastfuß eines Freileitungsmastens. Die Installation entsprechender Messvorrichtungen ist daher zeitaufwendig und erfordert eine genaue Ausführung, um fehlerhafte Messungen zu vermeiden. Weiterhin erfordert dieses Verfahren einen hinreichend großen Prüfstrom, damit Messfehler durch die verwendete Strommesseinrichtung den Messwert nur unwesentlich beeinflussen.

Ferner kann die lokale Erdungsimpedanz mit einem Hochfrequenzverfahren, welches auch in der EN 50522 angegeben ist, einfach und schnell durchgeführt werden. Dabei wird jedoch eine verhältnismäßig hohe Frequenz benötigt, um einen genauen Messwerte zu erhalten. Bei üblichen Messfrequenzen von 5 kHz treten Abweichungen im Bereich von 30 % im Vergleich zum Abheben des Erdseils auf. Genauere Messergebnisse liefern Messgeräte, welche mit bis zu 25 kHz messen. Dadurch wird jedoch der Messaufbau komplexer. Um beispielsweise Fehler durch Kopplungen bei Frequenzen im kHz Bereich zu vermeiden, kann eine Verwendung von geschirmten Koaxialleitungen erforderlich sein. Weiterhin können parasitäre kapazitive und induktive Kopplungen die Messung leicht verfälschen.

Die CN 113 009 237 A offenbart ein Verfahren zur Bestimmung einer Erdungsimpedanz nach dem Oberbegriff von Anspruch 1, bei dem eine Vielzahl von Testimpedanzwerten bei verschiedenen Messfrequenzen ermittelt wird und dann mittels eines Kurvenfits eine Zielmessfrequenz ermittelt wird.

ZUSAMMENFASSUNG DER ERFINDUNG

Es besteht ein Bedarf an verbesserten Möglichkeiten zum Messen von Erdungsimpedanzen von lokalen Erdungsvorrichtungen von energietechnischen Einrichtungen, welche ausreichend genaue Messergebnisse liefern und schnell und einfach mit einfachen Mitteln durchgeführt werden können.

**EP 4 469 811 B1**

Gemäß der vorliegenden Erfindung werden ein Verfahren zum Bestimmen einer Erdungsimpedanz einer Erdungsvorrichtung einer energietechnischen Einrichtung und eine Vorrichtung zum Bestimmen einer Erdungsimpedanz einer Erdungsvorrichtung einer energietechnischen Einrichtung bereitgestellt, wie sie in den unabhängigen Ansprüchen definiert sind. Die abhängigen Ansprüche definieren Ausführungsformen der Erfindung.

Bei einem erfindungsgemäßen Verfahren zum Bestimmen einer Erdungsimpedanz einer Erdungsvorrichtung einer energietechnischen Einrichtung werden mindestens zwei Impedanzwerte an der Erdungsvorrichtung bestimmt, während die Erdungsvorrichtung mit mindestens einer weiteren Erdungsvorrichtung von mindestens einer weiteren energietechnischen Einrichtung elektrisch verbunden ist. Beispielsweise kann die energietechnische Einrichtung ein Freileitungsmast sein, welcher während der Bestimmung der mindestens zwei Impedanzwerte über ein Erdseil mit weiteren geerdeten Freileitungsmasten verbunden ist. Jeder der mindestens zwei Impedanzwerte wird mit einem jeweiligen Prüfstrom mit einer jeweils vorgegebenen Frequenz bestimmt. Beispielsweise kann bei einem jeweils angelegten Prüfstrom eine entsprechende jeweilige Spannung über der Erdung gemessen werden und so der jeweilige Impedanzwert bestimmt werden. Die Frequenzen der jeweiligen Prüfströme sind unterschiedlich. Die Frequenzen der jeweiligen Prüfströme liegen beispielsweise in einem Bereich unter 1 kHz und vorzugsweise in der Nähe der jeweils verwendeten Netzfrequenz, insbesondere in einem Bereich von beispielsweise 10 Hz bis 100 Hz. Einer der Prüfströme kann beispielsweise eine Frequenz von 30 Hz aufweisen und ein weiterer der Prüfströme kann beispielsweise eine Frequenz von 70 Hz aufweisen. Es können mehr als zwei Impedanzwerte bestimmt werden, beispielsweise drei oder vier Impedanzwerte bei drei bzw. vier unterschiedlichen Frequenzen. Ferner wird mindestens ein Parameter eines Modells in Abhängigkeit von den mindestens zwei Impedanzwerten bestimmt. Das Modell repräsentiert die Erdungsvorrichtung und die mindestens eine weitere Erdungsvorrichtung. Bei mehr als zwei Impedanzwerten, können alle diese Impedanzwerte bei der Bestimmung der Parameter berücksichtigt werden. Der mindestens eine Parameter umfasst einen Näherungswert für die Erdungsimpedanz der Erdungsvorrichtung.

Durch die Verwendung des Modells, welches die Erdungsvorrichtung und die mindestens eine weitere Erdungsvorrichtung repräsentiert, können Prüfströme mit verhältnismäßig niedrigen Frequenzen verwendet werden, wodurch der Aufwand für die Messung deutlich geringer als bei dem oben genannten Hochfrequenzverfahren ist. Insbesondere kann durch die Verwendung der verhältnismäßig niedrigen Frequenzen, insbesondere von Frequenzen in der Nähe der Nennfrequenz oder Netzfrequenz, erfolgen, wodurch der Messaufbau vereinfacht wird und ein Einfluss potentieller Fehlerquellen, wie zum Beispiel kapazitive und induktive Kopplungen, minimiert wird. Ferner sind für die Erzeugung der Prüfspannungen und die Messung der Impedanzwerte bei den oben genannten verhältnismäßig niedrigen Frequenzen häufig bereits entsprechende Vorrichtungen vorhanden, welche in Verbindung mit dem oben beschriebenen Verfahren verwendet werden können, sodass diese Vorrichtungen wiederverwendet werden können und das Verfahren kostengünstig beispielsweise mittels einer entsprechenden Verarbeitungsvorrichtung oder einem Softwareprogramm für eine bestehende Verarbeitungsvorrichtung realisiert werden kann.

Das verwendete Modell stellt eine Annäherung an das reale Verhalten des Hochspannungssystems dar. Damit kann ein verhältnismäßig genauer Näherungswert für die Erdungsimpedanz der Erdungsvorrichtung ermittelt werden.

Gemäß einer Ausführungsform entspricht der Näherungswert für die Erdungsimpedanz in dem Modell im Wesentlichen einem lokalen Ausbreitungswiderstand der Erdungsvorrichtung. Die Erdungsvorrichtung der energietechnischen Einrichtung kann beispielsweise ein Erdungsnetz oder einen vermaschten Erder umfassen. Die energietechnische Einrichtung kann einen Freileitungsmast umfassen. Jede der weiteren energietechnischen Einrichtungen kann ebenfalls einen Freileitungsmast umfassen. Die energietechnische Einrichtung und die weiteren energietechnischen Einrichtungen können über ein Erdseil miteinander elektrisch verbunden sein. Insbesondere bei Freileitungsmasten, welche über einen Erdseil miteinander verbunden sind, kann eine hohe Genauigkeit für den Näherungswert für die Erdung Impedanz mithilfe des Modells erreicht werden.

Gemäß einer Ausführungsform wird in dem Modell eine Gesamtimpedanz der weiteren Erdungsvorrichtungen durch eine Reihenschaltung einer Reaktanz, z.B. einer Induktivität, und eines Widerstands repräsentiert. Beispielsweise können die Reaktanz und der Widerstand eine Summe von Induktivitäten, Kapazitäten, Widerständen und/oder Leitwerten eines Kettenleiters repräsentieren, welche durch das Erdseil und die Erdungsvorrichtungen der weiteren energietechnischen Einrichtungen gebildet werden. Insbesondere bei Freileitungsmasten liefert eine derartige Darstellung des Erdseils und der damit gekoppelten weiteren Erdungsvorrichtungen unter Verwendung des Modells eine hohe Genauigkeit für den Näherungswert für die lokale Erdungsimpedanz.

Bei einer Ausführungsform umfasst das Bestimmen des mindestens einen Parameters des Modells ein numerisches Approximationsverfahren. Alternativ oder zusätzlich kann der mindestens eine Parameter des Modells durch Anwenden eines genetischen Algorithmus bestimmt werden. Zum Beispiel kann der mindestens eine Parameter des Modells derart bestimmt werden, dass eine Euklidische Distanz in der komplexen Widerstandsebene zwischen Impedanzwerten des Modells und den aus den Messungen bestimmten Impedanzwerten minimal wird.

Gemäß einer weiteren Ausführungsform wird zum Bestimmen von einem jeweiligen Impedanzwert der mindestens zwei Impedanzwerte der jeweilige Prüfstrom mit der vorgegebenen Frequenz mittels eines Hilfserders in die Erdungsvorrichtung der energietechnischen Einrichtung eingespeist. Der Hilfserder kann beispielsweise in einer Entfernung von einigen Metern von der Erdungsvorrichtung, beispielsweise in einer Entfernung von 10 bis 100 m zu einem Erdungsnetz oder einem vermaschten Erder vorgesehen werden. Eine Stromquelle, welche den jeweiligen Prüfstrom erzeugt, wird beispielsweise mit dem Hilfserder und einem Anschluss der Erdungsvorrichtung gekoppelt. Eine jeweilige Spannung wird zwischen der Erdungsvorrichtung und einer von der Erdungsvorrichtung beabstandet angeordneten Sonde gemessen. Die Sonde kann ebenfalls in einer Entfernung von einigen Metern von der Erdungsvorrichtung, beispielsweise in einer Entfernung von 10 bis 100 m zu einem Erdungsnetz oder einem vermaschten Erder vorgesehen werden. Der jeweilige Impedanzwert wird in Abhängigkeit von dem jeweiligen Prüfstrom, der vorgegebenen Frequenz des jeweiligen Prüfstroms und der jeweils gemessenen Spannung bestimmt.

Bei einem weiteren Verfahren wird ein Reduktionsfaktor einer Erdungsvorrichtung einer energietechnischen Einrichtung, welche mit mindestens einer weiteren geerdeten energietechnischen Einrichtung gekoppelt ist, bestimmt. Der Reduktionsfaktor stellt die Stromaufteilung zwischen lokalem Erder und den verbundenen weiteren Erdungssystemen dar. Bei dem Verfahren wird eine Erdungsimpedanz der Erdungsvorrichtung wie zuvor beschrieben bestimmt. Ferner wird eine Gesamtimpedanz für die Erdungsvorrichtung und die damit verbundenen weiteren Erdungsvorrichtungen mittels des Modells zumindest näherungsweise bestimmt oder abgeschätzt. In Abhängigkeit von der Erdungsimpedanz und der Gesamtimpedanz wird der Reduktionsfaktor bestimmt. Neben den Messungen für die zuvor beschriebene Bestimmung der Erdungsimpedanz werden daher zur Bestimmung des Reduktionsfaktors keine weiteren Messungen benötigt, sodass der Reduktionsfaktor auf einfache Art und Weise mithilfe des Modells und den bereits verfügbaren Messwerten bestimmt werden kann.

Die zuvor beschriebenen Verfahren können mittels eines Prüfgeräts für die energietechnische Einrichtung automatischen durchgeführt werden. Beispielsweise können der Hilfserder für die Prüfstromeinspeisung und die Sonde für die Spannungsmessung installiert und über entsprechende elektrische Verbindungen mit dem Prüfgerät gekoppelt werden. Ferner kann das Prüfgerät mit der Erdungsvorrichtung elektrisch verbunden werden. Nachfolgend kann das Prüfgerät automatisch nacheinander die verschiedenen Prüfströme mit den verschiedenen Frequenzen einspeisen und entsprechende Spannungen zwischen der Sonde und der Erdungsvorrichtung messen und automatisch entsprechende Impedanzwerte bestimmen. Alternativ können die verschiedenen Prüfströme mit den verschiedenen Frequenzen auch gleichzeitig, d.h. überlagert, eingespeist werden, wobei mit Hilfe von entsprechenden Filtern die jeweils relevanten Frequenzanteile aus dem gemessenen Signal zurückgewonnen werden. Mithilfe des Modells, welches in der Prüfvorrichtung vorgesehen sein kann und welches die Erdungsvorrichtung und die mindestens eine weitere Erdungsvorrichtung repräsentiert, kann die Prüfvorrichtung automatisch einen Näherungswert für die Erdungsimpedanz der Erdungsvorrichtung bestimmen. Ferner kann die Prüfvorrichtung einen Reduktionsfaktor der Erdungsvorrichtung automatisch bestimmen. Die automatisch bestimmten Werte können beispielsweise auf einer Anzeigevorrichtung der Prüfvorrichtung angezeigt werden. Da das Modell weitere Erdungsvorrichtungen, mit denen die lokale Erdungsvorrichtung zum Zeitpunkt der Messung elektrisch verbunden ist, berücksichtigt, ist eine Entkopplung der lokalen Erdungsvorrichtung von diesen weiteren Erdungsvorrichtungen nicht erforderlich. Beispielsweise kann ein Erdseil während der Messung an einem Freileitungsmast weiterhin mit dem Freileitungsmast und weiteren Freileitungsmasten gekoppelt sein.

Gemäß der vorliegenden Erfindung wird ferner eine Vorrichtung zum Bestimmen einer Erdungsimpedanz einer Erdungsvorrichtung einer energietechnischen Einrichtung bereitgestellt. Die Vorrichtung umfasst eine Messvorrichtung, welche ausgestaltet ist, mindestens zwei Impedanzwerte an der Erdungsvorrichtung zu bestimmen, während die Erdungsvorrichtung mit mindestens einer weiteren Erdungsvorrichtung von mindestens einer weiteren energietechnischen Einrichtung elektrisch verbunden ist. Jeder der mindestens zwei Impedanzwerte wird mit einem jeweiligen Prüfstrom mit vorgegebener Frequenz bestimmt. Die Frequenzen der jeweiligen Prüfströme sind unterschiedlich. Die Vorrichtung umfasst ferner eine Verarbeitungsvorrichtung, welche ausgestaltet ist, mindestens einen Parameter eines Modells, welches die Erdungsvorrichtung und die mindestens eine weitere Erdungsvorrichtung repräsentiert, in Abhängigkeit von den mindestens zwei Impedanzwerten zu bestimmen. Der mindestens eine Parameter umfasst einen Näherungswert für die Erdungsimpedanz der Erdungsvorrichtung, also die lokale Erdungsimpedanz.

Die Vorrichtung kann zur Durchführung der zuvor beschriebenen Verfahren ausgestaltet sein, insbesondere derart, dass die Verfahrensschritte der zuvor beschriebenen Verfahren von der Vorrichtung automatisch ausgeführt werden.

Ein Prüfgerät für eine energietechnische Einrichtung kann die zuvor beschriebene Vorrichtung umfassen. Das Prüfgerät kann weitere Funktionalitäten aufweisen, beispielsweise Funktionalitäten für Verdrahtungs- und Polaritätsprüfungen, Bürdenmessungen, Schutzrelaisprüfungen, Übersetzungsmessungen für Strom- und Spannungswandler oder (Mikroohm-)Widerstandsmessungen.

Die beschriebene Erfindung ist sowohl auf Hochspannungseinrichtungen als auch auf Mittel- oder Niederspannungseinrichtungen als energietechnische Einrichtung, deren Erdungsimpedanz bestimmt wird, anwendbar. Demzufolge kann es sich bei der energietechnischen Einrichtung, deren Erdungsimpedanz bestimmt wird, beispielsweise um einen Hochspannungsmast oder auch einen Niederspannungsmast handeln.

KURZE BESCHREIBUNG DER FIGUREN

Die Erfindung wird nachfolgend unter Bezugnahme auf die Zeichnungen anhand bevorzugter Ausführungsformen näher erläutert. In den Zeichnungen bezeichnen identische Bezugzeichen identische Elemente.

Fig. 1 zeigt schematisch einen geerdeten Freileitungsmast, welcher über ein Erdseil in Verbindung mit mehreren weiteren Freileitungsmasten steht.

Fig. 2 zeigt schematisch eine Messanordnung zum Bestimmen einer Erdungsimpedanz einer Erdungsvorrichtung eines Freileitungsmastes gemäß einer Ausführungsform.

Fig. 3 zeigt schematisch ein Prüfgerät für eine energietechnische Einrichtung gemäß einer Ausführungsform.

Fig. 4 zeigt ein Verfahren zum Bestimmen einer Erdungsimpedanz einer Erdungsvorrichtung einer energietechnischen Einrichtung gemäß einer Ausführungsform.

Fig. 5 zeigt schematisch ein Modell eines lokalen Ausbreitungswiderstandes einer Erdungsvorrichtung einer energietechnischen Einrichtung in Verbindung mit einem Kettenleiter, welcher durch benachbarte energietechnische Einrichtungen und deren Erdungsvorrichtungen gebildet wird.

Fig. 6 zeigt einen Lösungsraum eines genetischen Algorithmus, welcher zum Bestimmen einer Erdungsimpedanz einer Erdungsvorrichtung mithilfe des Modells der Fig. 5 angewendet wird.

Fig. 7 zeigt eine Darstellung eines Frequenzverlaufs einer mithilfe des Modells der Fig. 5 modellierten Gesamtimpedanz an der Erdungsvorrichtung der energietechnischen Einrichtung.

DETAILLIERTE BESCHREIBUNG VON AUSFÜHRUNGSBEISPIELEN

Nachfolgend wird die vorliegende Erfindung anhand bevorzugter Ausführungsformen unter Bezugnahme auf die Figuren näher erläutert. In den Figuren bezeichnen gleiche Bezugszeichen gleiche oder ähnliche Elemente. Die Figuren sind schematische Darstellungen verschiedener Ausführungsformen der Erfindung. In den Figuren dargestellte Elemente sind nicht notwendigerweise maßstabsgetreu dargestellt. Vielmehr sind die verschiedenen in den Figuren dargestellten Elemente derart wiedergegeben, dass ihre Funktion und ihr Zweck dem Fachmann verständlich werden.
In den Figuren dargestellte Verbindungen und Kopplungen zwischen funktionellen Einheiten und Elementen können als direkte oder indirekte Verbindungen oder Kopplungen implementiert werden. Eine Verbindung oder Kopplung kann drahtgebunden oder drahtlos implementiert sein.

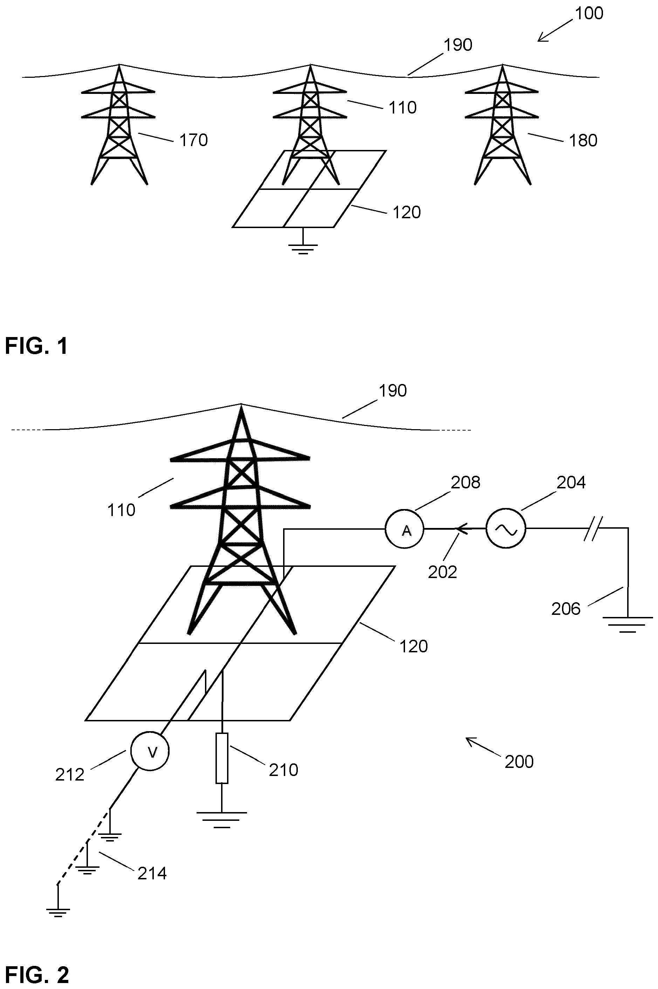

Fig. 1 zeigt schematisch einen Ausschnitt einer Hochspannungsübertragungsstrecke 100 mit drei Freileitungsmasten 110, 170 und 180. Die drei Freileitungsmasten 110, 170 und 180 sind über ein Erdseil 190 miteinander gekoppelt, sodass die Erdungsvorrichtungen der Freileitungsmasten 110, 170 und 180 elektrisch miteinander gekoppelt sind. Exemplarisch ist für den Freileitungsmast 110 eine dem Freileitungsmast 110 zugeordnete Erdungsvorrichtung 120 dargestellt. Die Erdungsvorrichtung 120 kann beispielsweise ein Erdungsnetz oder einen vermaschten Erder umfassen. Die Freileitungsmasten 110, 170 und 180 sind nur ein Beispiel für energietechnische Einrichtungen, welche jeweils eine entsprechende Erdungsvorrichtung umfassen und miteinander elektrisch verbunden sind. Andere Beispiele für entsprechende energietechnische Einrichtungen sind beispielsweise Hochspannungstransformatoren, Hochspannungsgeneratoren oder Hochspannungsschaltvorrichtungen. Obwohl nachfolgend hauptsächlich Bezug auf Freileitungsmasten genommen werden wird, können die nachfolgend beschriebenen Verfahren und Techniken auch auf andere energietechnische Einrichtungen angewendet werden.
Fig. 2 zeigt schematisch eine Messanordnung 200 zum Bestimmen einer lokalen Erdungsimpedanz der Erdungsvorrichtung 120 des Freileitungsmastes 110. Es ist zu beachten, dass die Messung durchgeführt werden kann, während der Freileitungsmast 110 über das Erdseil 190 mit weiteren Freileitungsmasten, beispielsweise den Freileitungsmasten 170 und 180, gekoppelt ist. D.h., die Erdungsvorrichtungen der Freileitungsmasten 170 und 180 und beliebiger weiterer energietechnischer Einrichtungen, welche über das Erdseil 190 mit dem Freileitungsmast 110 gekoppelt sind, stehen miteinander in elektrischer Verbindung.
Anders ausgedrückt wird eine Messung an der Erdungsvorrichtung 120 durch die Erdungsvorrichtungen der Freileitungsmasten 170 und 180 und weiterer energietechnischer Einrichtungen beeinflusst.
Um die korrekte Einrichtung und Funktionsweise der Erdungsvorrichtung 120 des Freileitungsmasts 110 nachzuweisen, um diesen beispielsweise mit berechneten oder geplanten Werten zu vergleichen oder Korrosionseffekte an der Erdungsvorrichtung 120 bei Wiederholungsprüfungen festzustellen, ist eine Bestimmung eines lokalen Ausbreitungswiderstands der Erdungsvorrichtung 120 erforderlich. In der Fig. 2 wird dieser lokale Ausbreitungswiderstand durch eine Erdungsimpedanz 210 dargestellt.

Bei der Messanordnung 200 wird ein Prüfstrom 202 von einer Stromquelle 204 mittels eines Hilfserders 206 in die Erdungsvorrichtung 120 eingespeist. Ein Wert des Prüfstroms 202 kann beispielsweise mit einem Strommessgerät 208 gemessen und einer in Fig. 2 nicht gezeigten Verarbeitungsvorrichtung zugeführt werden. Alternativ oder zusätzlich kann die Stromquelle 204 den Wert des aktuell ausgegebenen Prüfstroms 202 an die Verarbeitungsvorrichtung übermitteln. Der Hilfserder 206 kann in einer vorgegebenen ausreichenden Entfernung von der Erdungsvorrichtung 120 angeordnet sein. Ein Abstand zwischen dem Hilfserder 206 und der Erdungsvorrichtung 120 kann einige Meter, beispielsweise 10 m bis 100 m betragen. Die Stromquelle 204 ist in der Lage, den Prüfstrom mit einer vorgegebenen Frequenz zu erzeugen. Die vorgegebene Frequenz kann beispielsweise in einem Bereich von 10 Hz bis einigen 100 Hz liegen, beispielsweise in einem Bereich von 20 Hz bis 100 Hz. Die Stromquelle 204 ist in der Lage, den Prüfstrom bei mindestens zwei unterschiedlichen Frequenzen zu erzeugen, beispielsweise bei einer Frequenz von 30 Hz und einer Frequenz von 70 Hz.

Mithilfe eines Spannungsmessgerätes 212 wird eine Spannung mittels einer Spannungssonde 214 zwischen der Erdungsvorrichtung 120 und der Spannungssonde 214 gemessen. Die Spannungssonde 214 ist in ausreichendem Abstand zu der Erdungsvorrichtung 120 und auch in ausreichendem Abstand zu dem Hilfserder 206 angeordnet. Ein Abstand zwischen der Spannungssonde 214 und der Erdungsvorrichtung 120 kann einige Meter, beispielsweise 10 m bis 100 m betragen.

Das Spannungsmessgerät ist in der Lage, Spannungen bei verschiedenen Frequenzen zu messen, insbesondere bei Frequenzen, welche von der Stromquelle 204 für die Erzeugung des Prüfstroms verwendet werden. Das Spannungsmessgerät 212 kann ferner in der Lage sein, eine Phase zwischen dem von der Stromquelle 204 erzeugten Prüfstrom und der von dem Spannungsmessgerät 212 gemessenen Spannung zu bestimmen. Dazu kann das Spannungsmessgerät beispielsweise mit der Stromquelle 204 oder dem Strommessgerät 208 gekoppelt sein. Alternativ oder zusätzlich können das Strommessgerät 208, die Stromquelle 204 und/oder das Spannungsmessgerät 212 mit der in Fig. 2 nicht gezeigten Verarbeitungsvorrichtung verbunden sein, welche anhand von aktuellen Prüfstromwerten und gemessenen Spannungswerten eine Phasenlage zwischen Prüfstrom und gemessener Spannung ermitteln kann.

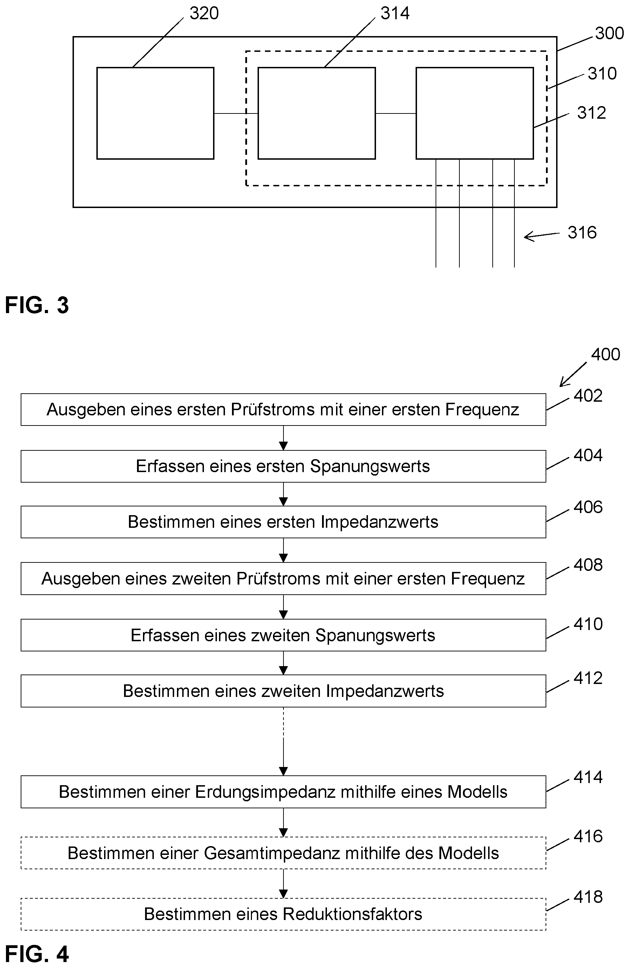

Fig. 3 zeigt schematisch ein Prüfgerät 300, welches für die in Fig. 2 gezeigte Messanordnung verwendet werden kann. Das Prüfgerät 300 umfasst eine Vorrichtung 310 zum Bestimmen einer Erdungsimpedanz sowie weitere Komponenten wie zum Beispiel eine Benutzerschnittstelle mit einer Anzeige und Bedienelementen sowie eine Stromversorgung. Diese weiteren Komponenten sind zusammengefasst in der Fig. 3 als Block 320 dargestellt. Die Vorrichtung 310 umfasst eine Messvorrichtung 312 und eine Verarbeitungsvorrichtung 314. Die Messvorrichtung 312 kann beispielsweise die Stromquelle 204, das Strommessgerät 208 und das Spannungsmessgerät 212, welche in Verbindung mit Fig. 2 beschrieben wurden, umfassen. Über entsprechende Verbindungsleitungen 316 kann die Messvorrichtung 312 mit der Erdungsvorrichtung 120, der Spannungssonde 214 und dem Hilfserder 206 gekoppelt werden. Die Messvorrichtung 312 ist somit in der Lage, zwei oder mehr Impedanzwerte an der Erdungsvorrichtung 120 zu bestimmen, die mit einem jeweiligen Prüfstrom mit jeweils vorgegebener Frequenz bestimmt werden, wobei die jeweiligen Frequenzen der jeweiligen Ströme unterschiedlich sind. Die Impedanzwerte werden von der Messvorrichtung 312 zu der Verarbeitungsvorrichtung 314 übertragen. Die Verarbeitungsvorrichtung 314 kann beispielsweise eine Mikroprozessorsteuerung sein, auf welcher ein Computerprogramm ausgeführt wird. Die Verarbeitungsvorrichtung 314 kann Befehle an die Messvorrichtung 312 übertragen, um die Messvorrichtung 312 zu steuern.

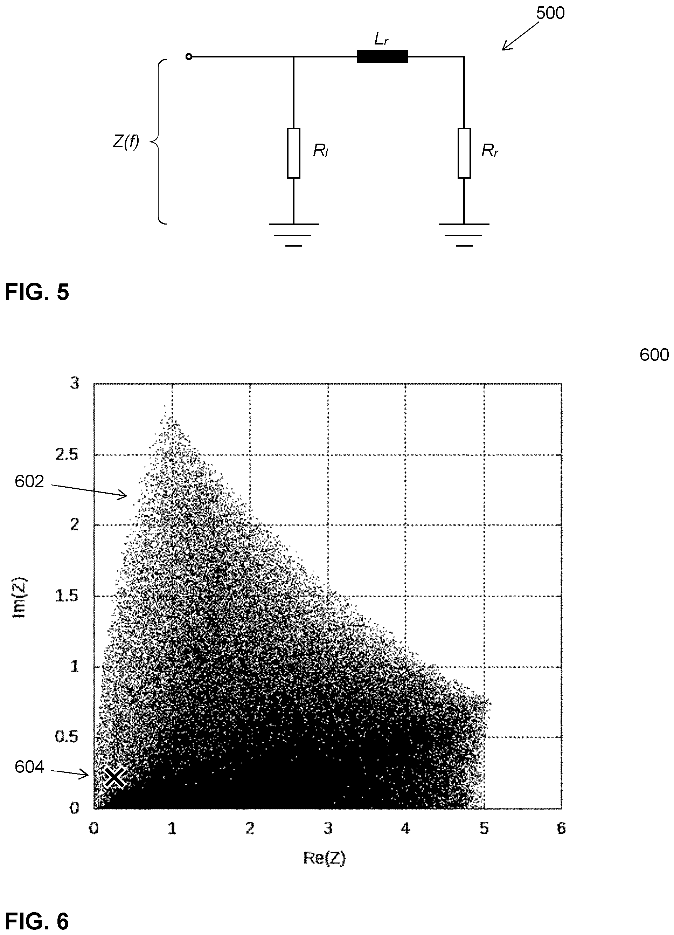

Beispielsweise kann die Verarbeitungsvorrichtung 314 die Messvorrichtung 312 ansteuern, um einen Prüfstrom mit einer vorgegebenen Frequenz auszugeben. In dem Computerprogramm ist ferner ein Modell implementiert, welches die Gesamtimpedanz der Erdung über die Erdungsvorrichtung 120 und über die Erdung der über das Erdseil 190 verbundenen weiteren Freileitungsmasten 170, 180 sowie gegebenenfalls weiterer energietechnischer Einrichtungen modelliert, ohne dass Details über die Erdungen der weiteren Freileitungsmasten 170, 180 und weiterer energietechnische Einrichtungen in dem Modell im Detail bekannt sein müssen. Parameter des Modells umfassen insbesondere die lokale Erdungsimpedanz 210, sodass diese mithilfe des Modells bestimmt werden kann. Das Modell wird in Verbindung mit Fig. 5 im Detail beschrieben werden.

Unter Bezugnahme auf Fig. 4 wird nachfolgend die Arbeitsweise der Prüfvorrichtung 300 in der Messanordnung 200 beschrieben werden. Das in Fig. 4 gezeigte Verfahren 400 umfasst Verfahrensschritte 402 bis 418, wobei insbesondere die Verfahrensschritte 416 und 418 optional sind.

Im Schritt 402 wird ein erster Prüfstrom mit einer ersten Frequenz $f_1$, beispielsweise einer Frequenz von 30 Hz, unter Verwendung des Hilfserders 206 in die Erdungsvorrichtung 120 eingespeist. Eine Stromstärke des ersten Prüfstroms kann beispielsweise einige Ampere betragen, beispielsweise im Bereich von 1 A bis 50 A. Abhängig von den Bedingungen kann jedoch auch ein geringerer Strom, beispielsweise in der Größenordnung von 100-200 mA, ausreichend sein. Im Schritt 404 wird eine erste Spannung zwischen der Erdungsvorrichtung 120 und der Spannungssonde 214 gemessen und eine Phasenlage der ersten Spannung zu dem ersten Prüfstrom bestimmt. Die Erzeugung des ersten Prüfstroms und das Messen der ersten Spannung können beispielsweise mittels der Messvorrichtung 312 unter der Steuerung der Verarbeitungsvorrichtung 314 erfolgen. Auf der Grundlage des ersten Prüfstroms, der ersten Spannung und der Phasenlage der ersten Spannung zu dem ersten Prüfstrom kann die Verarbeitungsvorrichtung 314 im Schritt 406 einen ersten Impedanzwert $Zm_1$ für die erste Frequenz $f_1$ bestimmen.

Im Schritt 408 wird ein zweiter Prüfstrom mit einer zweiten Frequenz $f_2$, beispielsweise einer Frequenz von 70 Hz, unter Verwendung des Hilfserders 206 in die Erdungsvorrichtung 120 eingespeist. Eine Stromstärke des zweiten Prüfstroms kann im Wesentlichen der Stromstärke des ersten Prüfstroms entsprechen, wobei dies jedoch nicht erforderlich ist, und der zweite Prüfstrom auch von dem ersten Prüfstrom abweichen kann. Im Schritt 410 wird eine zweite Spannung zwischen der Erdungsvorrichtung 120 und der Spannungssonde 214 gemessen und eine Phasenlage der zweiten Spannung zu dem zweiten Prüfstrom bestimmt. Beispielsweise kann die Messvorrichtung 312 unter der Steuerung der Verarbeitungsvorrichtung 314 den zweiten Prüfstrom erzeugen und die zweite Spannung messen. Aus dem zweiten Prüfstrom, der zweiten Spannung und der Phase zwischen der zweiten Spannung und dem zweiten Prüfstrom kann die Verarbeitungsvorrichtung 314 im Schritt 412 einen zweiten Impedanzwert $Zm_2$ für die zweite Frequenz $f_2$ bestimmen.

Wie durch den teilweise gestrichelten Pfeil in Fig. 4 dargestellt, können zwischen Schritt 412 und Schritt 414 weitere Impedanzwerte bei weiteren Frequenzen mithilfe einer Einspeisung weiterer Prüfströme und Messen weiterer Spannungen bestimmt werden und bei der nachfolgend beschriebenen Bestimmung der Erdungsimpedanz 210 verwendet werden. Aus Gründen der Übersichtlichkeit wird nachfolgend jedoch im Wesentlichen auf die Verwendung von nur zwei Impedanzwerten eingegangen, welche wie zuvor beschrieben bestimmt wurden.

Bei einer beispielhaften Durchführung des Verfahrens 400 wird der erste Prüfstrom mit einer Frequenz $f_1$ von 30 Hz eingespeist und eine entsprechende Impedanz $Zm_1$ gemessen und anschließend der zweite Prüfstrom mit einer Frequenz $f_2$ von 70 Hz eingespeist und eine entsprechende Impedanz $Zm_2$ gemessen. Das Ergebnis ist in der folgenden Tabelle (1) dargestellt, wobei die Impedanzen $Zm$ nach Betrag und Phase eingetragen sind.

Tabelle (1)

| Frequenz | $|Z_m|$ | Phase ($Z_m$) |
|---|---|---|
| 30.0 Hz | 0.22 Ohm | 37.89° |
| 70.0 Hz | 0.37 Ohm | 48.60° |

Zur Bestimmung der Erdungsimpedanz 210 wird ein Modell verwendet, welches die Erdungsvorrichtung 120 des Freileitungsmastes 110 sowie das Erdseil 190 und die damit verbundenen weiteren Freileitungsmasten 170, 180 und deren Erdungsvorrichtungen modelliert.

Fig. 5 zeigt ein Modell 500 in Form eines Ersatzschaltbilds für die Erdungsvorrichtung 120 des Freileitungsmastes 110 und die über das Erdseil 190 damit verbundenen weiteren Freileitungsmasten 170, 180 und deren Erdungsvorrichtungen. In dem Modell 500 stellt $R_l$ den lokalen Ausbreitungswiderstand dar. Insbesondere bei einem Erdungsnetz oder vermaschten Erder ist der induktive Anteil für eine näherungsweise Lösung vernachlässigbar. Daher kann der lokale Ausbreitungswiderstand $R_l$ als rein ohmscher Widerstand betrachtet werden. $L_r$ und $R_r$ repräsentieren die Summe der Widerstände, Induktivitäten und Kapazitäten eines Kettenleiters, welcher durch das Erdseil 190 am Freileitungsmast 110 und die Erdungsvorrichtungen der benachbarten Freileitungsmasten 170, 180 gebildet wird. Aufgrund dieses Modells ergibt sich die gesamte Erdungsimpedanz $Z(f)$ in Abhängigkeit von der Frequenz nach folgender Gleichung (1):

$$Z(f) = \cfrac{1}{\cfrac{1}{R_l} + \cfrac{1}{j2\pi f\, L_r + R_r}} \qquad (1)$$

Im Schritt 414 bestimmt die Verarbeitungsvorrichtung 314 passende Werte für $R_l$, $L_r$ und $R_r$, welche derart bestimmt werden, dass die sich ergebende Erdungsimpedanz $Z(f)$ möglichst gut den Messwerten $Zm=Rm+jXm$ bei der jeweiligen Frequenz entspricht. Dies kann beispielsweise über eine Minimierung einer euklidischen Distanz in der komplexen Widerstandsebene gemäß der folgenden Gleichung (2) erfolgen:

$$\delta = \sum_{n=1}^{M} |Z(f_n) - Z_{m,n}| = \sum_{n=1}^{M} \sqrt{\left(R(f_n) - R_{m,n}\right)^2 + \left(X(f_n) - X_{m,n}\right)^2} \qquad (2)$$

Dabei entspricht $M$ der Anzahl der Impedanzwerte $Zm_n$, die so ermittelt wurden, wie es zuvor unter Bezugnahme auf die Schritte 402 bis 412 beschrieben wurde. Zur Bestimmung der Werte der Parameter $R_l$, $L_r$ und $R_r$ werden mindestens zwei Impedanzwerte verwendet, d.h. $M$ ist größer gleich zwei. Wenn mehr als zwei Impedanzwerte zur Verfügung stehen, kann eine Bestimmungsgenauigkeit der Werte der Parameter $R_l$, $L_r$ und $R_r$ verbessert werden. In der Gleichung (2) ist $R(f_n)$ der Realteil der Erdungsimpedanz $Z(f_n)$ des Modells bei der Frequenz $f_n$ von dem gemessenen Impedanzwert $Zm_n$ und $X(f_n)$ ist der Imaginärteil der Erdungsimpedanz $Z(f_n)$ des Modells bei der Frequenz $f_n$ von dem gemessenen Impedanzwert $Zm_n$. $Rm_n$ und $Xm_n$ sind der Real- bzw. Imaginärteil des gemessenen Impedanzwerts $Zm_n$.

Mit einem Optimierungsverfahren bestimmt die Verarbeitungsvorrichtung 314 passende Werte für $R_l$, $L_r$ und $R_r$, sodass $\delta$ minimal wird. Dazu kann die Verarbeitungsvorrichtung 314 beispielsweise ein numerisches Approximationsverfahren oder einen genetischen Algorithmus verwenden. Bei der Verwendung eines genetischen Algorithmus wird als Fitnessfunktion die Gleichung (2) verwendet und somit $\delta$ minimiert.

Ein beispielhaft implementierter genetischer Algorithmus liefert für die oben genannten Messwerte ein in Fig. 6 gezeigtes Ergebnis. Fig. 6 zeigt den Lösungsraum 600 mit der Anfangspopulation 602 (schwarze Punkte) des genetischen Algorithmus bei 50 Hz. Ein minimales $\delta$ für die Gleichung (2) wurde an der Stelle 604 (gekennzeichnet durch ein weiß eingerahmt es 'x') gefunden und lieferte folgenden Parametersatz für das Modell:

Tabelle (2)

| $R_l$ | $L_r$ | $R_r$ | $\delta$ |
|---|---|---|---|
| 1,255 Ohm | 891 $\mu$H | 0,192 Ohm | 0,0135 Ohm |

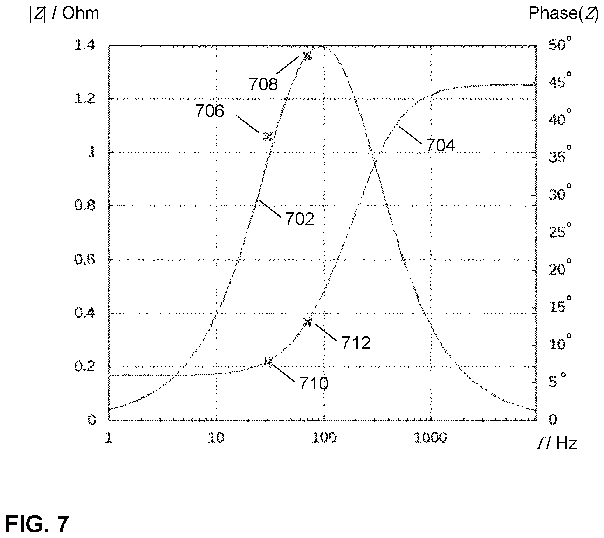

Für das in Fig. 5 gezeigte Modell ergibt sich mit den Parametern der Tabelle (2) ein in Fig. 7 gezeigter Verlauf der Impedanz $Z(f)$ über der Frequenz $f$ Ein Betrag der Impedanz $Z(f)$ über der Frequenz $f$ ist als Graph 702 und eine Phase der Impedanz $Z(f)$ über der Frequenz $f$ ist als Graph 704 gezeigt. Die entsprechenden aus der Messung ermittelten Werte 706 und 708 für die Phase der Impedanz bei 30 Hz bzw. 70 Hz und die entsprechenden aus der Messung ermittelten Werte 710 und 712 für den Betrag der Impedanz bei 30 Hz bzw. 70 Hz stimmen verhältnismäßig gut mit dem Modell überein.

Auf der Grundlage der Parameter, welche für das in Fig. 5 gezeigte Modell ermittelt wurden, kann somit der Erdungswiderstand $R_l$ des lokalen Erdungssystems berechnet werden. Der lokale Erdungswiderstand ermöglicht Aussagen über die Qualität des Erdungssystems. Bei der Berechnung eines neu zu errichtenden Erdungssystems wird ein Sollwert für den Erdungswiderstand berechnet oder eine bestimmte Auslegung des Erdungssystems festgelegt, von der angenommen werden kann, dass der resultierende Erdungswiderstand nach Errichtung des Mastes unter einem bestimmten Grenzwert liegt. Nach der Errichtung kann der mithilfe des Modells bestimmte Erdungswiderstand mit dem Sollwert verglichen werden und somit kontrolliert werden, ob er der Vorgabe hinreichend genau entspricht. Verschlechtert sich der lokale Erdungswiderstand $R_l$ über der Zeit, so kann dies auf eine Korrosion des Erdungssystems im Boden hindeuten.

Auf der Grundlage der für das in Fig. 5 gezeigte Modell ermittelten Parameter kann neben dem Erdungswiderstand $R_l$ des lokalen Erdungssystem auch ein Reduktionsfaktor $r$ berechnet werden. Der Reduktionsfaktor $r$ stellt eine Stromaufteilung zwischen der lokalen Erdungsvorrichtung 120 und den verbundenen anderen Erdungssystemen gemäß Gleichung (3) dar.

$$r = \frac{I_l}{I_g} = \frac{I_l}{I_l + I_r} \qquad (3)$$

Dabei ist $r$ der Anteil $I_l$ des Gesamtstroms $I_g$. Der Gesamtstrom $I_g$ setzt sich aus dem Strom $I_l$, welcher in das lokale Erdungssystem 120 fließt, und dem Strom $I_r$, welcher über das Erdseil 190 in die benachbarten Erdungssysteme fließt, zusammen. Der Gesamtstrom $I_g$ teilt sich proportional zu den entsprechenden Impedanzen gemäß Gleichung (4) auf.

$$r(f) = \frac{\frac{1}{R_l}}{\frac{1}{R_l} + \frac{1}{j2\pi f L_r + R_r}} = \frac{Z(f)}{R_l} \qquad (4)$$

Beispielsweise kann im Schritt 416 zunächst die Gesamtimpedanz $Z(f)$ bestimmt werden und im Schritt 418 aus der Gesamtimpedanz $Z(f)$ und dem Erdungswiderstand $R_l$ gemäß Gleichung (4) der Reduktionsfaktor $r$. Somit kann der Reduktionsfaktor $r$ sehr einfach zumindest näherungsweise ermittelt werden, ohne dass eine zusätzliche Messung des Stromflusses oder ein Abheben des Erdseils 190 durchgeführt werden muss. In dem oben genannten Beispiel der Tabelle (1) ergibt sich für den Reduktionsfaktor $r$ bei 50 Hz ein Wert von $r(50 Hz) = 0,164 + j0\text{-}162$ mit einem Betrag von $|r(50 Hz)|$

*=0,23.*

Auf der Grundlage des Reduktionsfaktors *r* kann bei einer Messung von Schritt- oder Berührungsspannung beispielsweise bestimmt werden, wie hoch diese Spannungen ohne andere verbundene Erdungssysteme wären. Derartige Spannungen können beispielsweise für sogenannte Worst Case Szenarien relevant sein.

**Patentansprüche**

1. Verfahren zum Bestimmen einer Erdungsimpedanz einer Erdungsvorrichtung einer energietechnischen Einrichtung, umfassend:

   - Bestimmen (406, 412) von mindestens zwei Impedanzwerten an der Erdungsvorrichtung (120), während die Erdungsvorrichtung (120) mit mindestens einer weiteren Erdungsvorrichtung von mindestens einer weiteren energietechnischen Einrichtung (170, 180) elektrisch verbunden ist, wobei jeder der mindestens zwei Impedanzwerte mit einem jeweiligen Prüfstrom mit vorgegebener Frequenz bestimmt wird, wobei die Frequenzen der jeweiligen Prüfströme unterschiedlich sind,
   **gekennzeichnet durch**
   - Bestimmen (414) mindestens eines Parameters eines Modells (500), welches die Erdungsvorrichtung (120) und die mindestens eine weitere Erdungsvorrichtung repräsentiert, in Abhängigkeit von den mindestens zwei Impedanzwerten, wobei der mindestens eine Parameter einen Näherungswert für die Erdungsimpedanz (210) der Erdungsvorrichtung (120) umfasst.

2. Verfahren nach Anspruch 1, wobei die Erdungsvorrichtung (120) der energietechnischen Einrichtung (110) ein Erdungsnetz oder einen vermaschten Erder umfasst.

3. Verfahren nach Anspruch 1 oder Anspruch 2, wobei in dem Modell (500) der Näherungswert für die Erdungsimpedanz (120) ein lokaler Ausbreitungswiderstand der Erdungsvorrichtung (120) ist.

4. Verfahren nach einem der vorhergehenden Ansprüche, wobei die energietechnische Einrichtung (110) und/oder die mindestens eine weitere energietechnische Einrichtung (170, 180) jeweils einen Freileitungsmast umfassen.

5. Verfahren nach einem der vorhergehenden Ansprüche, wobei die energietechnische Einrichtung (110) und die mindestens eine weitere energietechnische Einrichtung (170, 180) über ein Erdseil (190) miteinander elektrisch verbunden sind.

6. Verfahren nach einem der vorhergehenden Ansprüche, wobei in dem Modell (500) eine Gesamtimpedanz der mindestens einen weiteren Erdungsvorrichtung (170, 180) durch eine Reihenschaltung einer Reaktanz und eines Widerstands repräsentiert wird.

7. Verfahren nach Anspruch 6, wobei die Reaktanz und der Widerstand eine Summe von Induktivitäten und Kapazitäten eines Kettenleiters repräsentieren, welcher durch das Erdseil (190) und die mindestens eine weitere Erdungsvorrichtung (170, 180) gebildet wird.

8. Verfahren nach einem der vorhergehenden Ansprüche, wobei das Bestimmen (414) des mindestens einen Parameters des Modells (500) ein numerisches Approximationsverfahren umfasst.

9. Verfahren nach einem der vorhergehenden Ansprüche, wobei das Bestimmen (414) des mindestens einen Parameters des Modells (500) ein Anwenden eines genetischen Algorithmus umfasst.

10. Verfahren nach einem der vorhergehenden Ansprüche, wobei der mindestens eine Parameter des Modells (500) derart bestimmt wird, dass eine Euklidische Distanz in der komplexen Widerstandsebene zwischen Impedanzwerten des Modells (500) und den bestimmten mindestens zwei Impedanzwerten minimal wird.

11. Verfahren nach einem der vorhergehenden Ansprüche, wobei zum Bestimmen (406, 412) von einem jeweiligen Impedanzwert der mindestens zwei Impedanzwerte der jeweilige Prüfstrom mit der vorgegebenen Frequenz mittels eines Hilfserders (206) in die Erdungsvorrichtung (120) der energietechnischen Einrichtung (110) eingespeist wird und eine jeweilige Spannung zwischen der Erdungsvorrichtung (120) und einer von der Erdungsvorrichtung (120) beabstandet angeordneten Sonde (214) gemessen wird, wobei der jeweilige Impedanzwert in Abhängigkeit von dem jeweiligen Prüfstrom, der vorgegebenen Frequenz des jeweiligen Prüfstroms und der jeweils gemessenen Spannung bestimmt wird.

12. Verfahren zum Bestimmen eines Reduktionsfaktors einer Erdungsvorrichtung einer energietechnischen Einrichtung, welche mit mindestens einer weiteren geerdeten energietechnischen Einrichtung (170, 180) gekoppelt ist, umfassend:

   - Bestimmen (414) einer Erdungsimpedanz der Erdungsvorrichtung (120) gemäß einem Verfahren nach einem der vorhergehenden Ansprüche,
   - Bestimmen (416) einer Gesamtimpedanz für die Erdungsvorrichtung (120) und die damit verbundene mindestens eine weitere Erdungsvorrichtung mittels des Modells (500) und des mindestens einen Parameters, der für das Modell (500) bestimmt wurde, und
   - Bestimmen (418) des Reduktionsfaktors in Abhängigkeit von der Erdungsimpedanz und der Gesamtimpedanz.

13. Verfahren nach einem der vorhergehenden Ansprüche, wobei das Verfahren automatisch durch ein Prüfgerät (300) für die energietechnische Einrichtung (110) durchgeführt wird.

14. Vorrichtung zum Bestimmen einer Erdungsimpedanz einer Erdungsvorrichtung einer energietechnischen Einrichtung, umfassend:

   - eine Messvorrichtung (312), welche ausgestaltet ist, mindestens zwei Impedanzwerte an der Erdungsvorrichtung (120) zu bestimmen, während die Erdungsvorrichtung (120) mit mindestens einer weiteren Erdungsvorrichtung von mindestens einer weiteren energietechnischen Einrichtung (170, 180) elektrisch verbunden ist, wobei jeder der mindestens zwei Impedanzwerte mit einem jeweiligen Prüfstrom mit vorgegebener Frequenz bestimmt wird, wobei die Frequenzen der jeweiligen Prüfströme unterschiedlich sind, und
   **gekennzeichnet durch**
   - eine Verarbeitungsvorrichtung (314), welche ausgestaltet ist, mindestens einen Parameter eines Modells (500), welches die Erdungsvorrichtung (120) und die mindestens eine weitere Erdungsvorrichtung repräsentiert, in Abhängigkeit von den mindestens zwei Impedanzwerten zu bestimmen, wobei der mindestens eine Parameter einen Näherungswert für die Erdungsimpedanz (210) der Erdungsvorrichtung (120) umfasst.

15. Vorrichtung nach Anspruch 14, wobei die Vorrichtung (310) zur Durchführung des Verfahrens nach einem der Ansprüche 2-13 ausgestaltet ist.

16. Prüfgerät für eine energietechnische Einrichtung, umfassend eine Vorrichtung (310) nach Anspruch 14 oder Anspruch 15.

**Claims**

1. A method for determining a grounding impedance of a grounding device of a power engineering installation, comprising:

   - determining (406, 412) at least two impedance values on the grounding device (120), while the grounding device (120) is electrically connected to at least one further grounding device of at least one further power engineering installation (170, 180), wherein each of the at least two impedance values is determined with a respective test current at a specified frequency, wherein the frequencies of the respective test currents are different,
   **characterized by**
   - determining (414) at least one parameter of a model (500), which represents the grounding device (120) and the at least one further grounding device, as a function of the at least two impedance values, wherein the at least one parameter comprises an approximate value for the grounding impedance (210) of the grounding device (120).

2. The method according to claim 1, wherein the grounding device (120) of the power engineering installation (110) comprises a grounding network or a meshed grounding electrode.

3. The method according to claim 1 or claim 2, wherein, in the model (500), the approximate value for the grounding impedance (120) is a local ground resistance of the grounding device (120).

4. The method according to any one of the preceding claims, wherein the power engineering installation (110) and/or the at least one further power engineering installation (170, 180) respectively comprise one overhead line pylon.

5. The method according to any one of the preceding claims, wherein the power engineering installation (110) and the at least one further power engineering installation (170, 180) are electrically connected to one another via a ground wire (190).

6. The method according to any one of the preceding claims, wherein, in the model (500), a total impedance of the at least one further grounding device (170, 180) is represented by a series connection of a reactance and a resistance.

7. The method according to claim 6, wherein the reactance and the resistance represent a sum of inductances and capacitances of a chain conductor formed by the ground wire (190) and the at least one further grounding device (170, 180).

8. The method according to any one of the preceding claims, wherein the determination (414) of the at least one parameter of the model (500) comprises a numerical approximation method.

9. The method according to any one of the preceding claims, wherein the determination (414) of the at least one parameter of the model (500) comprises applying a genetic algorithm.

10. The method according to any one of the preceding claims, wherein the at least one parameter of the model (500) is determined in such a way that a Euclidean distance in the complex resistance plane between impedance values of the model (500) and the determined at least two impedance values becomes minimal.

11. The method according to any one of the preceding claims, wherein, to determine (406, 412) a respective impedance value of the at least two impedance values, the respective test current is fed into the grounding device (120) of the power engineering installation (110) at the specified frequency by means of an auxiliary ground electrode (206) and a respective voltage is measured between the grounding device (120) and a probe (214) arranged spaced apart from the grounding device (120), wherein the respective impedance value is determined as a function of the respective test current, the specified frequency of the respective test current and the voltage measured in each case.

12. A method for determining a reduction factor of a grounding device of a power engineering installation which is coupled to at least one further grounded power engineering installation (170, 180), comprising:

    - determining (414) a grounding impedance of the grounding device (120) according to a method according one of the previous claims,
    - determining (416) a total impedance for the grounding device (120) and the at least one further grounding device, which is connected thereto, by means of the model (500) and the at least one parameter which has been determined for the model (500), and
    - determining (418) the reduction factor as a function of the grounding impedance and the total impedance.

13. The method according to any one of the preceding claims, wherein the method is performed automatically by a test apparatus (300) for the power engineering installation (110).

14. A device for determining a grounding impedance of a grounding device of a power engineering installation, comprising:

    - a measuring device (312) which is configured to determine at least two impedance values on the grounding device (120), while the grounding device (120) is electrically connected to at least one further grounding device of at least one further power engineering installation (170, 180), wherein each of the at least two impedance values is determined with a respective test current at a specified frequency, wherein the frequencies of the respective test currents are different, and **characterized by**
    - a processing device (314) which is configured to determine at least one parameter of a model (500), which represents the grounding device (120) and the at least one further grounding device, as a function of the at least two impedance values, wherein the at least one parameter comprises an approximate value for the grounding impedance (210) of the grounding device (120).

15. The device according to claim 14, wherein the device (310) is configured for performing the method according to any one of claims 2-13.

16. A test apparatus for a power engineering installation, comprising a device (310) according to claim 14 or claim 15.

**Revendications**

1. Procédé de détermination d'une impédance de mise à la terre d'un dispositif de mise à la terre d'une installation énergétique, comprenant :

   - la détermination (406, 412) d'au moins deux valeurs d'impédance sur le dispositif de mise à la terre (120), tandis que le dispositif de mise à la terre (120) est connecté électriquement à au moins un autre dispositif de mise à la terre d'au moins une autre installation énergétique (170, 180), chacune des au moins deux valeurs d'impédance étant déterminée avec un courant de test respectif à une fréquence prédéterminée, les fréquences des courants de test respectifs étant différentes,
   **caractérisé par**
   - la détermination (414) d'au moins un paramètre d'un modèle (500) représentant le dispositif de mise à la terre (120) et le au moins un autre dispositif de mise à la terre, en fonction des au moins deux valeurs d'impédance, le au moins un paramètre comprenant une valeur approximative de l'impédance de mise à la terre (210) du dispositif de mise à la terre (120).

2. Procédé selon la revendication 1, dans lequel le dispositif de mise à la terre (120) de l'installation énergétique (110) comprend un réseau de mise à la terre ou une prise de terre maillée.

3. Procédé selon la revendication 1 ou la revendication 2, dans lequel, dans le modèle (500), la valeur approximative de l'impédance de mise à la terre (120) est une résistance de propagation locale du dispositif de mise à la terre (120).

4. Procédé selon l'une quelconque des revendications précédentes, dans lequel l'installation énergétique (110) et/ou la au moins une autre installation énergétique (170, 180) comprennent chacune un mât de ligne aérienne.

5. Procédé selon l'une quelconque des revendications précédentes, dans lequel l'installation énergétique (110) et la au moins une autre installation énergétique (170, 180) sont reliées électriquement l'un à l'autre par un câble de terre (190).

6. Procédé selon l'une quelconque des revendications précédentes, dans lequel, dans le modèle (500), une impédance totale du au moins un autre dispositif de mise à la terre (170, 180) est représentée par une connexion en série d'une réactance et d'une résistance.

7. Procédé selon la revendication 6, dans lequel la réactance et la résistance représentent une somme d'inductances et de capacités d'un conducteur de chaîne qui est formée par le câble de mise à la terre (190) et le au moins un autre dispositif de mise à la terre (170, 180).

8. Procédé selon l'une quelconque des revendications précédentes, dans lequel la détermination (414) du au moins un paramètre du modèle (500) comprend un procédé d'approximation numérique.

9. Procédé selon l'une quelconque des revendications précédentes, dans lequel la détermination (414) du au moins un paramètre du modèle (500) comprend l'application d'un algorithme génétique.

10. Procédé selon l'une quelconque des revendications précédentes, dans lequel le au moins un paramètre du modèle (500) est déterminé de manière à minimiser une distance euclidienne dans le plan de résistance complexe entre les valeurs d'impédance du modèle (500) et les au moins deux valeurs d'impédance déterminées.

11. Procédé selon l'une quelconque des revendications précédentes, dans lequel, pour déterminer (406, 412) une valeur d'impédance respective des au moins deux valeurs d'impédance, le courant de test respectif à la fréquence prédéterminée est injecté dans le dispositif de mise à la terre (120) de l'installation énergétique (110) au moyen d'une prise de terre auxiliaire (206) et une tension respective entre le dispositif de mise à la terre (120) et une sonde (214) agencée de manière espacée du dispositif de mise à la terre (120) est mesurée, la valeur d'impédance respective étant déterminée en fonction du courant de test respectif, de la fréquence prédéterminée du courant de test respectif et de la tension mesurée respective.

12. Procédé pour déterminer un facteur de réduction d'un dispositif de mise à la terre d'une installation énergétique couplé à au moins une autre installation énergétique mise à la terre (170, 180), comprenant :

- déterminer (414) une impédance de mise à la terre du dispositif de mise à la terre (120) selon un procédé selon l'une des revendications précédentes,
- déterminer (416) une impédance totale pour le dispositif de mise à la terre (120) et le au moins un autre dispositif de mise à la terre associé au moyen du modèle (500) et du au moins un paramètre déterminé pour le modèle (500), et
- déterminer (418) le facteur de réduction en fonction de l'impédance de mise à la terre et de l'impédance totale.

13. Procédé selon l'une quelconque des revendications précédentes, dans lequel le procédé est mis en œuvre automatiquement par un appareil de test (300) pour l'installation énergétique (110).

14. Dispositif de détermination d'une impédance de mise à la terre d'un dispositif de mise à la terre d'une installation énergétique, comprenant :

- un dispositif de mesure (312) conçu pour déterminer au moins deux valeurs d'impédance sur le dispositif de mise à la terre (120), tandis que le dispositif de mise à la terre (120) est connecté électriquement à au moins un autre dispositif de mise à la terre d'au moins une autre installation énergétique (170, 180), chacune des au moins deux valeurs d'impédance étant déterminée avec un courant de test respectif à une fréquence prédéterminée, les fréquences des courants de test respectifs étant différentes, et **caractérisé par**
- un dispositif de traitement (314) conçu pour déterminer au moins un paramètre d'un modèle (500) représentant le dispositif de mise à la terre (120) et le au moins un autre dispositif de mise à la terre, en fonction des au moins deux valeurs d'impédance, le au moins un paramètre comprenant une valeur approximative de l'impédance de mise à la terre (210) du dispositif de mise à la terre (120).

15. Dispositif selon la revendication 14, dans lequel le dispositif (310) est conçu pour mettre en œuvre le procédé selon l'une quelconque des revendications 2 à 13.

16. Appareil de test pour une installation énergétique, comprenant un dispositif (310) selon la revendication 14 ou la revendication 15.

**FIG. 1**

**FIG. 2**

320    314    300

310

312

316

**FIG. 3**

400

402

| Ausgeben eines ersten Prüfstroms mit einer ersten Frequenz |

404

| Erfassen eines ersten Spanungswerts |

406

| Bestimmen eines ersten Impedanzwerts |

408

| Ausgeben eines zweiten Prüfstroms mit einer ersten Frequenz |

410

| Erfassen eines zweiten Spanungswerts |

412

| Bestimmen eines zweiten Impedanzwerts |

414

| Bestimmen einer Erdungsimpedanz mithilfe eines Modells |

416

| Bestimmen einer Gesamtimpedanz mithilfe des Modells |

418

| Bestimmen eines Reduktionsfaktors |

**FIG. 4**

**FIG. 5**

**FIG. 6**

**FIG. 7**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- CN 113009237 A